# EUROPÄISCHE PATENTANMELDUNG

(11) **EP 2 684 927 A2**
(43) Veröffentlichungstag der Anmeldung: **15.01.2014**
(21) Anmeldenummer: 13168551.3
(22) Anmeldetag: 21.05.2013
(51) Int. Cl.: C09J 7/02, B32B 5/18

(54) **Kantenschutzband**

(30) Priorität: 20.06.2012 DE 102012210386
(71) Anmelder: Tesa SE, 20253 Hamburg (DE)
(72) Erfinder: Kluge-Paletta, Werner, 21244 Buchholz Hamburg (DE); Stein, Andreas, 22455 Hamburg (DE); Watzke, Wilhelm, 22523 Hamburg (DE)

(57) **Zusammenfassung**

Bei einem selbstklebenden Kantenschutzband soll die Schutzwirkung für Glaskanten verbessert werden. Dies gelingt durch Zurverfügungstellung eines Klebebandes, das in auf das zu bedeckende Substrat gerichteter Reihenfolge eine Trägerschicht (Hartphase) und eine Weichphase umfassend einen Polymerschaum, eine viskoelastische Masse und/oder eine elastomere Masse umfasst, wobei die Dicke der Hartphase ≤ 150 µm beträgt, die Dicke der Weichphase ≥ 200 µm beträgt und das Verhältnis der Dicke der Weichphase zur Dicke der Hartphase ≥ 4 beträgt. Weitere Gegenstände der Erfindung sind ein Solarmodul, das ein um mindestens einen Teil seiner Kanten geklebtes erfindungsgemäßes Klebeband umfasst, sowie die Verwendung des erfindungsgemäßen Klebebandes zum Schutz von Kanten eines Solarmoduls.

## Beschreibung

Die vorliegende Erfindung betrifft das technische Gebiet der Klebebänder. Insbesondere schlägt die Erfindung ein selbstklebendes Kantenschutzband vor, das eine verbesserte Schutzwirkung für Glaskanten, speziell für Glaskanten von Solarmodulen, aufweist.

Die Nutzung von Photovoltaik-Anlagen zur Erzeugung von Strom aus Sonnenlicht erfährt eine anhaltende Verbreitung. Herkömmliche Photovoltaik-Anlagen bestehen in der Regel aus einer Vielzahl miteinander verschalteter Solarmodule. Diese Module, die auch als Photovoltaikmodule oder kurz als PV-Module bezeichnet werden, enthalten wiederum miteinander verschaltete Solarzellen, in denen die Umwandlung der Energie des Sonnenlichts in elektrische Energie erfolgt. Solarzellen basieren auf Silizium und werden daher häufig auch als Silizium-Wafer bezeichnet. Am weitesten verbreitet sind Dickschicht - Siliziumzellen, entweder als monokristalline (c-Si) oder multikristalline Zellen (mc-Si).

Zunehmend gewinnen alternative Technologien an Bedeutung. Beispielsweise werden Substrate direkt mit einer photoaktiven Schicht überzogen. Die daraus resultierenden Dünnschicht-Solarmodule zeichnen sich neben den geringeren Fertigungskosten auch durch ein geringeres Gewicht aus. Jedoch ist der Wirkungsgrad dieser Module derzeit noch geringer als bei der Wafer-Technologie. Darüber hinaus ist man dazu übergegangen, auch flexible Folien mit photoaktiven Schichten zu versehen und somit flexible Solarmodule herzustellen. Dennoch kommt den herkömmlichen Ausgestaltungsformen nach wie vor die größte Bedeutung zu.

Eine wichtige Anforderung an Solarmodule ist es, dass sie gegenüber mechanischen Einwirkungen hinreichend geschützt sind. Dies gestaltet sich nicht problemlos, da Solarmodule Glassubstrate enthalten, welche naturgemäß Erschütterungen nur eingeschränkt widerstehen und leicht brechen. Solarmodule sind beim Transport und ihrer Verarbeitung sowie Montage vielfältiger mechanischer Beanspruchung ausgesetzt. Um sie davor zu schützen, werden üblicherweise vollständig mit einem Aluminiumrahmen umgeben. Der Kantenschutz von Solarmodulen mit Hilfe von Aluminiumrahmen bringt jedoch eine Reihe von Nachteilen mit sich. Neben einem relativ hohen Kostenanteil für den Rahmen an den Gesamtkosten des Solarmoduls zählen dazu das durch den Rahmen eingebrachte Gewicht, die Vielzahl der Prozessschritte bei der Aluminiumverrahmung und das Risiko von Glasbruch beim Anbringen des Rahmens. Es ist daher wünschenswert, Alternativen zur Aluminiumverrahmung von Solarmodulen bereitzustellen.

Derartige Alternativen können beispielsweise selbstklebende Schutzbänder sein, mit denen die Kanten der Module umgeben werden. Die Gebrauchsmusterschriften DE 20 2006 016 394 U1 und DE 20 2008 006 624 U1 beschreiben Kantenschutzbänder zum Schutz der Ränder von Mehrfachglasscheiben, wobei die Schutzbänder spezielle funktionale Elemente wie Gleitfolien oder eine metallische Außenschicht enthalten.

DE 10 2009 014 873 A1 beschreibt ein Haftklebeband mit einer Gasdiffusionsrate gegenüber Wasserdampf von maximal 5 g/(m²*d) pro mm Klebebanddicke, das als selbstklebendes Dichtungsband in Solarmodulen verwendet werden kann.

EP 1 719 808 A2 hat ein Haftklebstofflaminat zum Gegenstand, das eine äußere Filmschicht, eine Polymer-basierte klebende Basisschicht und eine Klebkraftverstärkungsschicht, die zumindest ein Polymer und einen Klebkraftverstärker enthält, umfasst. Das Laminat wird hergestellt, indem zunächst die Filmschicht und die klebende Basisschicht coextrudiert werden und anschließend die klebkraftverstärkende Schicht auf die klebende Basisschicht aufgebracht wird.

Bei selbstklebenden Kantenschutzbändern tritt häufig ein Konflikt zwischen der für den mechanischen Schutz erforderlichen Steifheit des Tapes einerseits und der für das Umhüllen der Kanten notwendigen Biegsamkeit andererseits auf. Es besteht daher ein anhaltender Bedarf an Kantenschutzbändern für Solarmodule mit ausgeprägter Schutzwirkung gegen mechanische Einflüsse, die sich leicht und dauerhaft auf die zu schützenden Kanten applizieren lassen.

Aufgabe der vorliegenden Erfindung ist es, ein selbstklebendes Band zum Schutz von Glaskanten bereitzustellen, welches Glaskanten dauerhaft und wirksam vor mechanischer Beschädigung, wie sie beispielsweise durch Stoß- oder Abrasionseinwirkung hervorgerufen wird, schützt. Das Band soll insbesondere in seiner Schutzwirkung nicht durch ein "Aufstellen" und ein damit verbundenes Ablösen vom Substrat eingeschränkt werden.

Der Lösung der Aufgabe liegt der Grundgedanke der Erfindung zugrunde, spezifische Ausgestaltungen je mindestens einer Hart- und einer Weichphase miteinander zu kombinieren. Ein erster Gegenstand der Erfindung ist daher ein Klebeband zum Schutz von Glaskanten, das in auf das zu bedeckende Substrat gerichteter Reihenfolge eine Trägerschicht (Hartphase) und eine Weichphase umfasst, die einen Polymerschaum, eine viskoelastische Masse und/oder eine elastomere Masse umfasst, wobei die Dicke der Hartphase ≤ 150 µm beträgt, die Dicke der Weichphase ≥ 200 µm beträgt und das Verhältnis der Dicke der Weichphase zur Dicke der Hartphase ≥ 4 beträgt. Ein derartiges Klebeband bietet einen hervorragenden Kantenschutz gegenüber mechanischen Einflüssen, beispielsweise gegenüber Stoß-, Schlag- und/oder Abrasionseinwirkung und reduziert somit die Glasbruchrate insbesondere bei größeren Solarmodulen. Der erreichte Schutz der Kanten ist dauerhaft, da ein Ablösen vom Klebesubstrat aufgrund zu hoher Biegemomente des Tapes im Vergleich zur Klebkraft vermieden werden kann.

Das erfindungsgemäße Klebeband umfasst eine Trägerschicht, die erfindungsgemäß auch als Hartphase bezeichnet wird. Die Polymerbasis der Hartphase ist erfindungsgemäß bevorzugt ausgewählt aus der Gruppe bestehend aus Polyvinylchloriden (PVC), Polyethylenterephthalaten (PET), Polyurethanen, Polyolefinen, Polybutylenterephthalaten (PBT), Polycarbonaten, Polymethylmethacrylaten (PMMA), Polyvinylbutyralen (PVB), Ionomeren und Mischungen aus zwei oder mehreren der vorstehend aufgeführten Polymere. Besonders bevorzugt ist die Polymerbasis der Hartphase ausgewählt aus der Gruppe bestehend aus Polyvinylchloriden, Polyethylenterephthalaten, Polyurethanen, Polyolefinen und Mischungen aus zwei oder mehreren der vorstehend aufgeführten Polymere. Die Hartphase ist im Wesentlichen eine Polymerfolie, deren Polymerbasis aus den vorstehenden Materialien ausgewählt ist. Unter einer "Polymerfolie" wird eine dünne, flächige, flexible, aufwickelbare Bahn verstanden, deren Materialbasis im Wesentlichen von einem oder mehreren Polymer(en) gebildet wird.

Unter "Polyurethanen" werden in weitgefasstem Sinne polymere Substanzen verstanden, in denen sich wiederholende Einheiten durch Urethan-Gruppierungen -NH-CO-O- miteinander verknüpft sind.

Unter "Polyolefinen" werden Polymere verstanden, die stoffmengenbezogen zu mindestens 50% Wiederholungseinheiten der allgemeinen Struktur -[-CH₂-CR¹R²-]ₙ- enthalten, worin R¹ für ein Wasserstoffatom und R² für ein Wasserstoffatom oder für eine lineare oder verzweigte, gesättigte aliphatische oder cycloaliphatische Gruppe steht. Soweit die Polymerbasis der Hartphase Polyolefine umfasst, handelt es sich bei diesen besonders bevorzugt um Polyethylene, insbesondere um Polyethylene mit ultrahoher Molmasse (UHMWPE).

Unter der "Polymerbasis" wird erfindungsgemäß das Polymer beziehungsweise werden erfindungsgemäß die Polymere verstanden, das/die den größten Gewichtsanteil aller in der betreffenden Schicht beziehungsweise Phase enthaltenen Polymere ausmacht/ausmachen.

Die Dicke der Hartphase beträgt erfindungsgemäß ≤ 150 µm. Bevorzugt beträgt die Dicke der Hartphase 10 bis 150 µm, besonders bevorzugt 30 bis 120 µm und insbesondere 50 bis 100 µm, beispielsweise 70 bis 85 µm. Unter der "Dicke" wird erfindungsgemäß die Ausdehnung der betreffenden Schicht beziehungsweise Phase entlang der z-Ordinate eines gedachten Koordinatensystems verstanden, bei dem die durch die Maschinenrichtung und die Querrichtung zur Maschinenrichtung aufgespannte Ebene die x-y-Ebene bildet. Erfindungsgemäß wird die Dicke durch Messung an mindestens fünf verschiedenen Stellen der betreffenden Schicht beziehungsweise Phase und anschließende Bildung des arithmetischen Mittels aus den erhaltenen Messergebnissen ermittelt. Die Dickenmessung der Hartphase erfolgt dabei in Einklang mit DIN EN ISO 4593.

Bevorzugt weist die Hartphase des erfindungsgemäßen Klebebandes eine Biegesteifigkeit von maximal 10 mN/mm auf. Die Biegesteifigkeit wird erfindungsgemäß ermittelt, indem ein Probestreifen des zu untersuchenden Materials mit einer Größe von 15 mm x 75 mm auf dem Probentisch fixiert wird. Der Probentisch ist um 30° schwenkbar, so dass ein zu untersuchendes Medium beim Schwenken einen Kraftsensor berührt. Die durch den Sensor ermittelte Kraft stellt einen der Biegesteifigkeit vergleichbaren Wert dar. Ein erfindungsgemäß geeignetes Gerät zur Ermittlung der Biegesteifigkeit ist zum Beispiel das Softometer KWS der Firma Wolf.

Das erfindungsgemäße Klebeband umfasst weiterhin eine Weichphase, die einen Polymerschaum, eine viskoelastische Masse und/oder eine elastomere Masse umfasst. Die Polymerbasis der Weichphase ist bevorzugt ausgewählt aus Polyolefinen, Polyacrylaten, Polyurethanen und Mischungen aus zwei oder mehreren der vorstehend aufgeführten Polymere.

Unter einem "Polymerschaum" wird erfindungsgemäß ein Gebilde aus gasgefüllten kugel-oder polyederförmigen Zellen verstanden, welche durch flüssige, halbflüssige, hochviskose oder feste Zellstege begrenzt werden; ferner ist der Hauptbestandteil der Zellstege ein Polymer oder ein Gemisch mehrerer Polymere.

Unter einer "viskoelastischen Masse" wird ein Material verstanden, das neben Merkmalen der reinen Elastizität (Zurückkehren in den Ausgangszustand nach äußerer mechanischer Einwirkung) auch Merkmale einer viskosen Flüssigkeit zeigt, beispielsweise das Auftraten innerer Reibung bei Deformation. Insbesondere werden Haftklebemassen auf Polymerbasis als viskoelastische Massen angesehen.

Unter einer "elastomeren Masse" wird ein Material verstanden, das gummielastisches Verhalten aufweist und bei 20°C wiederholt auf mindestens das Zweifache seiner Länge gedehnt werden kann und nach Aufhebung des für die Dehnung erforderlichen Zwanges sofort wieder annähernd seine Ausgangsdimension einnimmt.

Bezüglich des erfindungsgemäß geltenden Verständnisses der Begriffe "Polymerbasis", "Polyurethane" und "Polyolefine" gilt das oben Gesagte. Unter "Polyacrylaten" werden Polymere verstanden, deren stoffmengenbezogene Monomerbasis zu mindestens 50% aus Acrylsäure, Methacrylsäure, Acrylsäureestern und/oder Methacrylsäureestern besteht, wobei Acrylsäureester und/oder Methacrylsäureester zumindest anteilig generell und bevorzugt zu mindestens 50% enthalten sind. Insbesondere wird unter einem "Polyacrylat" ein Polymerisat verstanden, welches durch radikalische Polymerisation von Acryl- und/oder Methylacrylmonomeren sowie gegebenenfalls weiteren, copolymerisierbaren Monomeren erhältlich ist.

Besonders bevorzugt ist die Polymerbasis der Weichphase ausgewählt aus Polyolefinen, Polyacrylaten und Mischungen aus zwei oder mehreren der vorstehend aufgeführten Polymere. Sofern Polyolefine zu der Polymerbasis der Weichphase gehören, sind diese bevorzugt ausgewählt aus Polyethylenen, Ethylen-Vinylacetat-Copolymeren (EVA) und Gemischen aus Polyethylenen und Ethylen-Vinylacetat-Copolymeren (PE/EVA-Blends). Die Polyethylene können dabei verschiedene Polyethylen-Typen sein, beispielsweise HDPE, LDPE, LLDPE, Blends aus diesen Polyethylen-Typen und/oder Gemische davon.

In einer Ausführungsform der Erfindung umfasst die Weichphase einen Schaum und jeweils eine ober- und unterhalb der geschäumten Schicht angeordnete Haftklebeschicht, wobei die Polymerbasis des Schaums aus einem oder mehreren Polyolefin(en) besteht und die Polymerbasis der Haftklebeschichten aus einem oder mehreren Polyacrylat(en) besteht. Besonders bevorzugt besteht die Polymerbasis des Schaums dabei aus einem oder mehreren Polyethylen(en), Ethylen-Vinylacetat-Copolymer(en) und Gemischen aus einem oder mehreren Polyethylen(en) und/oder Ethylen-Vinylacetat-Copolymer(en). Ganz besonders bevorzugt besteht die Polymerbasis des Schaums dabei aus einem oder mehreren Polyethylen(en).

Der Polyolefin-basierte Schaum selbst ist nicht oder nur sehr wenig haftklebrig. Der Verbund mit der Hartphase beziehungsweise dem Substrat wird daher vorteilhaft durch die Haftklebeschichten bewirkt. Die Schäumung des Polyolefin-basierten Ausgangsmaterials des Schaums wird bevorzugt durch zugesetztes Treibgas im Sinne einer physikalischen Schäumung und/oder durch ein chemisches Schäumungsmittel, beispielsweise durch Azodicarbonsäurediamin, hervorgerufen.

In einer weiteren Ausführungsform der Erfindung ist die Weichphase ein haftklebriger Polymerschaum, dessen Polymerbasis aus einem oder mehreren Polyacrylaten besteht. "Haftklebriger Schaum" bedeutet, dass der Schaum selbst eine Haftklebemasse ist und somit ein Auftrag einer zusätzlichen Haftklebeschicht nicht erforderlich ist. Dies ist vorteilhaft, weil im Herstellungsprozess weniger Schichten zusammengefügt werden müssen und das Risiko von Ablösungserscheinungen und anderen unerwünschten Phänomenen an den Schichtgrenzen sinkt.

Unter einer "Haftklebemasse" wird erfindungsgemäß ein Material verstanden, dessen abgebundener Film bei Raumtemperatur in trockenem Zustand permanent klebrig und klebfähig bleibt, wobei eine Verklebung durch leichten Anpressdruck sofort auf einer Vielzahl unterschiedlicher Substrate erfolgt.

Die Polyacrylate sind bevorzugt erhältlich durch zumindest anteiliges Einpolymerisieren von funktionellen, mit Epoxidgruppen vernetzungsfähigen Monomeren. Besonders bevorzugt handelt es sich dabei um Monomere mit Säuregruppen (besonders Carbonsäure-, Sulfonsäure oder Phosphonsäuregruppen) und/oder Hydroxygruppen und/oder Säureanhydridgruppen und/oder Epoxidgruppen und/oder Amingruppen; insbesondere bevorzugt sind carbonsäuregruppenhaltige Monomere. Es ist ganz besonders vorteilhaft, wenn die Polyacrylate einpolymerisierte Acrylsäure und/oder Methacrylsäure aufweisen. All diese Gruppen weisen eine Vernetzungsfähigkeit mit Epoxidgruppen auf, wodurch die Polyacrylate vorteilhaft einer thermischen Vernetzung mit eingebrachten Epoxiden zugänglich wird.

Weitere Monomere, die als Comonomere für die Polyacrylate verwendet werden können, sind neben Acrylsäure- und/oder Methacrylsäureestern mit bis zu 30 C-Atomen beispielsweise Vinylester von bis zu 20 C-Atome enthaltenden Carbonsäuren, Vinylaromaten mit bis zu 20 C-Atomen, ethylenisch ungesättigte Nitrile, Vinylhalogenide, Vinylether von 1 bis 10 C-Atome enthaltenden Alkoholen, aliphatische Kohlenwasserstoffe mit 2 bis 8 C-Atomen und 1 oder 2 Doppelbindungen oder Mischungen dieser Monomeren.

Die Eigenschaften des betreffenden Polyacrylats lassen sich insbesondere über eine Variation der Glasübergangstemperatur des Polymers durch unterschiedliche Gewichtsanteile der einzelnen Monomere beeinflussen. Die Polyacrylate können vorzugsweise auf die folgende Monomerzusammensetzung zurückgeführt werden:
a) Acrylsäureester und/oder Methacrylsäureester der folgenden Formel

   CH₂ = C(R^{I})(COOR^{II})

   wobei R^{I} = H oder CH₃ und R^{II} ein Alkylrest mit 4 bis 14 C-Atomen ist,
b) olefinisch ungesättigte Monomere mit funktionellen Gruppen der für eine Reaktivität mit Epoxidgruppen bereits definierten Art,
c) optional weitere Acrylate und/oder Methacrylate und/oder olefinisch ungesättigte Monomere, die mit der Komponente (a) copolymerisierbar sind.

Bevorzugt beruhen die Polyacrylate auf einer Monomerenzusammensetzung, in der die Monomere der Komponente (a) mit einem Anteil von 45 bis 99 Gew.-%, die Monomere der Komponente (b) mit einem Anteil von 1 bis 15 Gew.-% und die Monomere der Komponente (c) mit einem Anteil von 0 bis 40 Gew.-% enthalten sind (die Angaben sind bezogen auf die Monomermischung für das "Basispolymer", also ohne Zusätze eventueller Additive zu dem fertigen Polymer, wie Harze etc). In diesem Fall weist das Polymerisationsprodukt eine Glastemperatur ≤ 15 °C (DMA bei geringen Frequenzen) und haftklebende Eigenschaften auf.

Die Monomere der Komponente (a) sind insbesondere weichmachende und/oder unpolare Monomere. Vorzugsweise werden als Monomere (a) Acryl- und Methacrylsäureester mit Alkylgruppen bestehend aus 4 bis 14 C-Atomen, besonders bevorzugt 4 bis 9 C-Atomen, eingesetzt. Beispiele für derartige Monomere sind n-Butylacrylat, n-Butylmethacrylat, n-Pentylacrylat, n-Pentylmethacrylat, n-Amylacrylat, n-Hexylacrylat, n-Hexylmethacrylat, n-Heptylacrylat, n-Octylacrylat, n-Octylmethacrylat, n-Nonylacrylat, Isobutylacrylat, Isooctylacrylat, Isooctylmethacrylat, und deren verzweigte Isomere, wie zum Beispiel 2-Ethylhexylacrylat oder 2-Ethylhexylmethacrylat.

Die Monomere der Komponente (b) sind insbesondere olefinisch ungesättigte Monomere mit funktionellen Gruppen, insbesondere mit funktionellen Gruppen, die eine Reaktion mit Epoxidgruppen eingehen können.

Bevorzugt werden für die Komponente (b) Monomere mit funktionellen Gruppen eingesetzt, die ausgewählt sind aus der Gruppe umfassend: Hydroxy-, Carboxy-, Sulfonsäure- oder Phosphonsäuregruppen, Säureanhydride, Epoxide, Amine.

Besonders bevorzugte Beispiele für Monomere der Komponente (b) sind Acrylsäure, Methacrylsäure, Itaconsäure, Maleinsäure, Fumarsäure, Crotonsäure, Aconitsäure, Dimethylacrylsäure, β-Acryloyloxypropionsäure, Trichloracrylsäure, Vinylessigsäure, Vinylphosphonsäure, Itasconsäure, Maleinsäureanhydrid, Hydroxyethylacrylat, Hydroxypropylacrylat, Hydroxyethylmethacrylat, Hydroxypropylmethacrylat, 6-Hydroxyhexylmethacrylat, Allylalkohol, Glycidylacrylat, Glycidylmethacrylat.

Prinzipiell können als Komponente (c) alle vinylisch funktionalisierten Verbindungen eingesetzt werden, die mit der Komponente (a) und/oder der Komponente (b) copolymerisierbar sind. Die Monomere der Komponente (c) können zur Einstellung der Eigenschaften der resultierenden Haftklebemasse dienen.

Beispielhafte Monomere der Komponente (c) sind:
Methylacrylat, Ethylacrylat, Propylacrylat, Methylmethacrylat, Ethylmethacrylat, Benzylacrylat, Benzylmethacrylat, sec-Butylacrylat, *tert*-Butylacrylat, Phenylacrylat, Phenylmethacrylat, Isobornylacrylat, Isobornylmethacrylat, *tert*-Butylphenylacrylat, *tert-*Butylaphenylmethacrylat, Dodecylmethacrylat, Isodecylacrylat, Laurylacrylat, n-Undecylacrylat, Stearylacrylat, Tridecylacrylat, Behenylacrylat, Cyclohexylmethacrylat, Cyclopentylmethacrylat, Phenoxyethylacrlylat, Phenoxyethylmethacrylat, 2-Butoxyethylmethacrylat, 2-Butoxyethylacrylat, 3,3,5-Trimethylcyclohexylacrylat, 3,5-Dimethyladamantylacrylat, 4-Cumylphenylmethacrylat, Cyanoethylacrylat, Cyanoethylmethacrylat, 4-Biphenylacrylat, 4-Biphenylmethacrylat, 2-Naphthylacrylat, 2-Naphthylmethacrylat, Tetrahydrofufurylacrylat, Diethylaminoethylacrylat, Diethylaminoethylmethacrylat, Dimethylaminoethyl-acrylat, Dimethylaminoethylmethacrylat, 2-Butoxyethylacrylat, 2-Butoxyethylmethacrylat, 3-Methoxyacrylsäuremethylester, 3-Methoxybutylacrylat, Phenoxyethylacrlylat, Phenoxyethylmethacrylat, 2-Phenoxyethylmethacrylat, Butyldiglykolmethacrylat, Ethylenglycolacrylat, Ethylenglycolmonomethylacrylat, Methoxy Polyethylenglykolmethacrylat 350, Methoxy Polyethylenglykolmethacrylat 500, Propylenglycolmonomethacrylat, Butoxydiethylenglykolmethacrylat, Ethoxytriethylenglykolmethacrylat, Octafluoropentylacrylat, Octafluoropentylmethacrylat, 2,2,2-Trifluoroethylmethacrylat, 1,1,1,3,3,3-Hexafluoroisopropylacrylat, 1,1,1,3,3,3-Hexafluoroisopropylmethacrylat, 2,2,3,3,3-Pentafluoropropylmethacrylat, 2,2,3,4,4,4-Hexafluorobutylmethacrylat, 2,2,3,3,4,4,4-Heptafluorobutylacrylat, 2,2,3,3,4,4,4-Heptafluorobutylmethacrylat, 2,2,3,3,4,4,5,5,6,6,7,7,8,8,8-Pentadecafluorooctylmethacrylat, Dimethylaminopropylacrylamid, Dimethylaminopropylmethacrylamid, N-(1-Methyl-undecyl)acrylamid, N-(n-Butoxymethyl)acrylamid, N-(Butoxymethyl)methacrylamid, N-(Ethoxymethyl)acrylamid, N-(n-Octadecyl)acrylamid, weiterhin N,N-Dialkyl-substituierte Amide, wie beispielsweise *N,N-*Dimethylacrylamid, N,N-Dimethylmethacrylamid, N-Benzylacrylamide, *N*-Isopropylacrylamid, *N*-*tert*-Butylacrylamid, *N*-*tert-*Octylacrylamid, N-Methylolacrylamid, N-Methylolmethacrylamid, Acrylnitril, Methacrylnitril, Vinylether, wie Vinylmethylether, Ethylvinylether, Vinylisobutylether, Vinylester, wie Vinylacetat, Vinylchlorid, Vinylhalogenide, Vinylidenchlorid, Vinylidenhalogenide, Vinylpyridin, 4-Vinylpyridin, N-Vinylphthalimid, N-Vinyllactam, N-Vinylpyrrolidon, Styrol, a- und p-Methylstyrol, a-Butylstyrol, 4-n-Butylstyrol, 4-n-Decylstyrol, 3,4-Dimethoxystyrol. Makromonomere wie 2-Polystyrolethylmethacrylat (Molekulargewicht Mw von 4000 bis 13000 g/mol), Poly(methylmethacrylat)ethylmethacrylat (Mw von 2000 bis 8000 g/mol).

Monomere der Komponente (c) können vorteilhaft auch derart gewählt werden, dass sie funktionelle Gruppen enthalten, die eine nachfolgende strahlenchemische Vernetzung (beispielsweise durch Elektronenstrahlen, UV) unterstützen. Geeignete copolymerisierbare Photoinitiatoren sind zum Beispiel Benzoinacrylat und acrylatfunktionalisierte Benzophenonderivate. Monomere, die eine Vernetzung durch Elektronenbestrahlung unterstützen, sind zum Beispiel Tetrahydrofufurylacrylat, *N*-*tert*-Butylacrylamid und Allylacrylat.

Die Herstellung der Polyacrylate ("Polyacrylate" wird im Rahmen der Erfindung als synonym mit "Poly(meth)acrylate" verstanden) kann nach dem Fachmann geläufigen Verfahren geschehen, insbesondere vorteilhaft durch konventionelle radikalische Polymerisationen oder kontrollierte radikalische Polymerisationen. Die Polyacrylate können durch Copolymerisation der monomeren Komponenten unter Verwendung der üblichen Polymerisationsinitiatoren sowie gegebenenfalls von Reglern hergestellt werden, wobei bei den üblichen Temperaturen in Substanz, in Emulsion, zum Beispiel in Wasser oder flüssigen Kohlenwasserstoffen, oder in Lösung polymerisiert wird.

Vorzugsweise werden die Polyacrylate durch Polymerisation der Monomere in Lösungsmitteln, insbesondere in Lösungsmitteln mit einem Siedebereich von 50 bis 150 °C, vorzugsweise von 60 bis 120 °C unter Verwendung der üblichen Mengen an Polymerisationsinitiatoren, die im allgemeinen bei 0,01 bis 5, insbesondere bei 0,1 bis 2 Gew.-% (bezogen auf das Gesamtgewicht der Monomeren) liegen, hergestellt.

Prinzipiell eignen sich alle dem Fachmann geläufigen, üblichen Initiatoren. Beispiele für Radikalquellen sind Peroxide, Hydroperoxide und Azoverbindungen, zum Beispiel Dibenzoylperoxid, Cumolhydroperoxid, Cyclohexanonperoxid, Di-*t*-butylperoxid, Cyclohexylsulfonylacetylperoxid, Diisopropylpercarbonat, *t*-Butylperoktoat, Benzpinacol. In einer sehr bevorzugten Vorgehensweise wird als radikalischer Initiator 2,2'-Azobis(2-methylbutyronitril) (Vazo® 67™ der Firma DuPont) oder 2,2'-Azobis(2-methylpropionitril) (2,2'-Azobisisobutyronitril; AIBN; Vazo® 64™ der Firma DuPont) verwendet.

Als Lösungsmittel für die Herstellung der Polyacrylate kommen Alkohole wie Methanol, Ethanol, n-und iso-Propanol, n-und iso-Butanol, vorzugsweise Isopropanol und/oder Isobutanol, sowie Kohlenwasserstoffe wie Toluol und insbesondere Benzine eines Siedebereichs von 60 bis 120 °C in Frage. Ferner können Ketone wie vorzugsweise Aceton, Methylethylketon, Methylisobutylketon und Ester wie Essigsäureethylester sowie Gemische von Lösungsmitteln der genannten Art eingesetzt werden, wobei Gemische, die Isopropanol, insbesondere in Mengen von 2 bis 15 Gew.-%, bevorzugt 3 bis 10 Gew.-%, bezogen auf das eingesetzte Lösungsmittelgemisch, enthalten, vorgezogen werden.

Bevorzugt erfolgt nach der Herstellung (Polymerisation) der Polyacrylate eine Aufkonzentration, und die weitere Verarbeitung der Polyacrylate erfolgt im Wesentlichen lösemittelfrei. Die Aufkonzentration des Polymerisats kann in Abwesenheit von Vernetzerund Beschleunigersubstanzen geschehen. Es ist aber auch möglich, eine dieser Verbindungsklassen dem Polymerisat bereits vor der Aufkonzentration zuzusetzen, so dass die Aufkonzentration dann in Gegenwart dieser Substanz(en) erfolgt.

Die Polymerisate können nach dem Aufkonzentrationsschritt in einen Compounder überführt werden. Gegebenenfalls können die Aufkonzentration und die Compoundierung auch im selben Reaktor stattfinden.

Die gewichtsmittleren Molekulargewichte M_{W} der Polyacrylate liegen bevorzugt in einem Bereich von 20.000 bis 2.000.000 g/mol; sehr bevorzugt in einem Bereich von 100.000 bis 1.000.000 g/mol, äußerst bevorzugt in einem Bereich von 150.000 bis 500.000 g/mol (die Angaben des mittleren Molekulargewichtes M_{W} und der Polydisperistät PD in dieser Schrift beziehen sich auf die Bestimmung per Gelpermeationschromatographie). Dazu kann es vorteilhaft sein, die Polymerisation in Gegenwart geeigneter Polymerisationsregler wie Thiole, Halogenverbindungen und/oder Alkohole durchzuführen, um das gewünschte mittlere Molekulargewicht einzustellen.

Das Polyacrylat hat vorzugsweise einen K-Wert von 30 bis 90, besonders bevorzugt von 40 bis 70, gemessen in Toluol (1 %ige Lösung, 21 °C). Der K-Wert nach Fikentscher ist ein Maß für das Molekulargewicht und die Viskosität des Polymerisats.

Besonders geeignet sind Polyacrylate, die eine enge Molekulargewichtsverteilung (Polydispersität PD < 4) haben. Diese Massen haben trotz eines relativ niedrigen Molekulargewichts nach dem Vernetzen eine besonders gute Scherfestigkeit. Zudem ermöglicht die niedrigere Polydispersität eine leichtere Verarbeitung aus der Schmelze, da die Fließviskosität gegenüber einem breiter verteilten Polyacrylat bei weitgehend gleichen Anwendungseigenschaften geringer ist. Eng verteilte Poly(meth)acrylate können vorteilhaft durch anionische Polymerisation oder durch kontrollierte radikalische Polymerisationsmethoden hergestellt werden, wobei letzteres besonders gut geeignet ist. Beispiele für derartige Polyacrylate, die nach dem RAFT-Verfahren hergestellt werden, sind in der US 6,765,078 B2 und US 6,720,399 B2 beschrieben. Auch über N-Oxyle lassen sich entsprechende Polyacrylate herstellen, wie beispielsweise in der EP 1 311 555 B1 beschrieben ist. Auch die Atom Transfer Radical Polymerization (ATRP) lässt sich in vorteilhafter Weise zur Synthese eng verteilter Polyacrylate einsetzen, wobei als Initiator bevorzugt monofunktionelle oder difunktionelle sekundäre oder tertiäre Halogenide und zur Abstraktion des(r) Halogenids(e) Cu-, Ni-, Fe-, Pd-, Pt-, Ru-, Os-, Rh-, Co-, Ir-, Ag- oder Au-Komplexe eingesetzt werden. Die unterschiedlichen Möglichkeiten der ATRP sind in den Schriften US 5,945,491 A, US 5,854,364 A und US 5,789,487 A beschrieben.

Die Monomere zur Herstellung der Polyacrylate enthalten bevorzugt anteilig funktionelle Gruppen, die geeignet sind, mit Epoxidgruppen Verknüpfungsreaktionen einzugehen. Dies ermöglicht vorteilhaft eine thermische Vernetzung der Polyacrylate durch Reaktion mit Epoxiden. Unter Verknüpfungsreaktionen werden insbesondere Additions- und Substitutionsreaktionen verstanden. Bevorzugt kommt es also zu einer Verknüpfung der die funktionellen Gruppen tragenden Bausteine mit Epoxidgruppen tragenden Bausteinen, insbesondere im Sinne einer Vernetzung der die funktionellen Gruppen tragenden Polymerbausteine über Epoxidgruppen tragende Vernetzermoleküle als Verknüpfungsbrücken. Bei den epoxidgruppenhaltigen Substanzen handelt es sich bevorzugt um multifunktionelle Epoxide, also solche mit mindestens zwei Epoxidgruppen; entsprechend kommt es bevorzugt insgesamt zu einer mittelbaren Verknüpfung der die funktionellen Gruppen tragenden Bausteine.

Das Polyacrylat beziehungsweise die Polyacrylate sind bevorzugt durch Verknüpfungsreaktionen - insbesondere im Sinne von Additions- oder Substitutionsreaktionen - von in ihnen enthaltenen funktionellen Gruppen mit thermischen Vernetzern vernetzt. Es können alle thermischen Vernetzer verwendet werden, die sowohl eine ausreichend lange Verarbeitungszeit gewährleisten, sodass es nicht zu einer Vergelung während des Verarbeitungsprozesses kommt, als auch zu einer schnellen Nachvernetzung des Polymers auf den gewünschten Vernetzungsgrad bei niedrigeren Temperaturen als der Verarbeitungstemperatur, insbesondere bei Raumtemperatur, führen. Möglich ist beispielsweise eine Kombination aus Carboxyl-, Amin- und/oder Hydroxygruppen enthaltenden Polymeren und Isocyanten als Vernetzer, insbesondere den in der EP 1 791 922 A1 beschriebenen aliphatischen oder mit Aminen deaktivierten trimerisierten Isocyanaten.

Geeignete Isocyanate sind insbesondere trimerisierte Derivate von MDI [4,4-Methylen-di(phenylisocyanat)], HDI [Hexamethylendiisocyanat, 1,6-Hexylendiisocyanat] und/oder IPDI [Isophorondiisocyanat, 5-Isocyanato-1-isocyanatomethyl-1,3,3-trimethylcyclohexan], beispielsweise die Typen Desmodur® N3600 und XP2410 (jeweils BAYER AG: Aliphatische Polyisocyanate, niedrigviskose HDI-Trimerisate). Ebenfalls geeignet ist die oberflächendeaktivierte Dispersion von mikronisiertem trimerisiertem IPDI BUEJ 339®, jetzt HF9 ® (BAYER AG).

Grundsätzlich zur Vernetzung geeignet sind aber auch andere Isocyanate wie Desmodur VL 50 (Polyisocyanate am MDI-Basis, Bayer AG), Basonat F200WD (aliphatisches Polyisocyanat, BASF AG), Basonat HW100 (wasseremulgierbares polyfunktionelles Isocyanat auf HDI-Basis, BASF AG), Basonat HA 300 (allophanatmodifiziertes Polyisocyanat auf Isocyanurat. HDI-Basis, BASF) oder Bayhydur VPLS2150/1 (hydrophil modifiziertes IPDI, Bayer AG).

Bevorzugt wird der thermische Vernetzer, beispielsweise das trimerisierte Isocyanat, zu 0,1 bis 5 Gew.-%, insbesondere zu 0,2 bis 1 Gew.-%, bezogen auf die Gesamtmenge des zu vernetzenden Polymers, eingesetzt.

Bevorzugt umfasst der thermische Vernetzer mindestens eine epoxidgruppenhaltige Substanz. Bei den epoxidgruppenhaltigen Substanzen handelt es sich insbesondere um multifunktionelle Epoxide, also solche mit zumindest zwei Epoxidgruppen; entsprechend kommt es insgesamt zu einer mittelbaren Verknüpfung der die funktionellen Gruppen tragenden Bausteine. Die epoxidgruppenhaltigen Substanzen können sowohl aromatische als auch aliphatische Verbindungen sein.

Hervorragend geeignete multifunktionelle Epoxide sind Oligomere des Epichlorhydrins, Epoxyether mehrwertiger Alkohole (insbesondere Ethylen-, Propylen-, und Butylenglycole, Polyglycole, Thiodiglycole, Glycerin, Pentaerythrit, Sorbit, Polyvinylalkohol, Polyallylalkohol und ähnliche), Epoxyether mehrwertiger Phenole [insbesondere Resorcin, Hydrochinon, Bis-(4-hydroxyphenyl)-methan, Bis-(4-hydroxy-3-methylphenyl)-methan, Bis-(4-hydroxy-3,5-dibromphenyl)-methan, Bis-(4-hydroxy-3,5-difluorphenyl)-methan, 1,1-Bis-(4-hydroxyphenyl)ethan, 2,2-Bis-(4-hydroxyphenyl)propan, 2,2-Bis-(4-hydroxy-3-methylphenyl)-propan, 2,2-Bis-(4-hydroxy-3-chlorphenyl)-propan, 2,2-Bis-(4-hydroxy-3,5-dichlorphenyl)-propan, 2,2-Bis-(4-hydroxy-3,5-dichlorphenyl)-propan, Bis-(4-hydroxyphenyl)-phenylmethan, Bis-(4-hydroxyphenyl)-phenylmethan, Bis-(4-hydroxyphenyl)diphenylmethan, Bis (4-hydroxyphenyl)-4'-methylphenylmethan, 1,1-Bis-(4-hydroxyphenyl)-2,2,2-trichlorethan, Bis-(4-hydroxyphenyl)-(4-chlorphenyl)-methan, 1,1-Bis-(4-hydroxyphenyl)-cyclohexan, Bis-(4-hydroxyphenyl)-cyclohexylmethan, 4,4'-Dihydroxydiphenyl, 2,2'-Dihydroxydiphenyl, 4,4'-Dihydroxydiphenylsulfon] sowie deren Hydroxyethylether, Phenol-Formaldehyd-Kondensationsprodukte, wie Phenolalkohole, Phenolaldehydharze und ähnliche, S- und N-haltige Epoxide (zum Beispiel N,N-Diglycidylanillin, N,N'-Dimethyldiglycidyl-4,4-Diaminodiphenylmethan) sowie Epoxide, welche nach üblichen Verfahren aus mehrfach ungesättigten Carbonsäuren oder einfach ungesättigten Carbonsäureresten ungesättigter Alkohole hergestellt worden sind, Glycidylester, Polyglycidylester, die durch Polymerisation oder Mischpolymerisation von Glycidylestern ungesättigter Säuren gewonnen werden können oder aus anderen sauren Verbindungen (Cyanursäure, Diglycidylsulfid, cyclischem Trimethylentrisulfon bzw. deren Derivaten und anderen) erhältlich sind.

Sehr geeignete Ether sind beispielsweise 1,4-Butandioldiglycidether, Polyglycerol-3-Glycidether, Cyclohexandimethanoldiglycidether, Glycerintriglycidether, Neopentylglykoldiglycidether, Pentaerythrittetraglycidether, 1,6-Hexandioldiglycidether), Polypropylenglykoldiglycidether, Trimethylolpropantriglycidether, Pentaerythrittetraglycidether, Bisphenol-A-diglycidether und Bisphenol-F-diglycidether.

Besonders bevorzugt ist die Verwendung eines beispielsweise in der EP 1 978 069 A1 beschriebenen Vernetzer-Beschleuniger-Systems ("Vernetzungssystem"), um eine bessere Kontrolle sowohl über die Verarbeitungszeit, Vernetzungskinetik sowie den Vernetzungsgrad zu erhalten. Das Vernetzer-Beschleuniger-System umfasst zumindest eine epoxidgruppenhaltige Substanz als Vernetzer und zumindest eine bei einer Temperatur unterhalb der Schmelztemperatur des zu vernetzenden Polymers für Vernetzungsreaktionen mittels epoxidgruppenhaltigen Verbindungen beschleunigend wirkende Substanz als Beschleuniger.

Als Beschleuniger werden besonders bevorzugt Amine (formell als Substitutionsprodukte des Ammoniaks aufzufassen; in den folgenden Formeln sind diese Substituenten durch "R" dargestellt und umfassen insbesondere Alkyl- und/oder Arylreste und/oder andere organische Reste) eingesetzt, insbesondere bevorzugt solche Amine , die mit den Bausteinen der zu vernetzenden Polymere keine oder nur geringfüge Reaktionen eingehen.

Prinzipiell können als Beschleuniger sowohl primäre (NRH₂), sekundäre (NR₂H) als auch tertiäre Amine (NR₃) gewählt werden, selbstverständlich auch solche, die mehrere primäre und/oder sekundäre und/oder tertiäre Amingruppen aufweisen. Besonders bevorzugte Beschleuniger sind aber tertiäre Amine wie beispielweise Triethylamin, Triethylendiamin, Benzyldimethylamin, Dimethylamino-methylphenol, 2,4,6-Tris-(N,N-dimethylaminomethyl)-phenol, N,N'-Bis(3-(dimethyl-amino)propyl)harnstoff. Als Beschleuniger können vorteilhaft auch multifunktionelle Amine wie Diamine, Triamine und/oder Tetramine eingesetzt werden. Hervorragend geeignet sind zum Beispiel Diethylentriamin, Triethylentetramin, Trimethylhexamethylendiamin.

Als Beschleuniger werden darüber hinaus bevorzugt Aminoalkohole verwendet. Besonders bevorzugt werden sekundäre und/oder tertiäre Aminoalkohole eingesetzt, wobei im Falle mehrerer Aminfunktionalitäten pro Molekül bevorzugt mindestens eine, bevorzugt alle Aminfunktionalitäten sekundär und/oder tertiär sind. Als bevorzugte Aminoalkohol-Beschleuniger können Triethanolamin, N,N-Bis(2-hydroxypropyl)ethanolamin, N-Methyldiethanolamin, N-Ethyldiethanolamin, 2-Aminocyclohexanol, Bis(2-hydroxycyclohexyl)methylamin, 2-(Diisopropylamino)ethanol, 2-(Dibutylamino)ethanol, N-Butyldiethanolamin, N-Butylethanolamin, 2-[Bis(2-hydroxyethyl)amino]-2-(hydroxymethyl)-1,3-propandiol, 1-[Bis(2-hydroxyethyl)amino]-2-propanol, Triisopropanolamin, 2-(Dimethylamino)ethanol, 2-(Diethylamino)ethanol, 2-(2-Dimethylaminoethoxy)ethanol, N,N,N'-Trimethyl-N'-hydroxyethylbisaminoethylether, N,N,N'-Trimethylaminoethylethanolamin und/oder N,N,N'-Trimethylaminopropylethanolamin eingesetzt werden.

Weitere geeignete Beschleuniger sind Pyridin, Imidazole (wie beispielsweise 2-Methylimidazol) und 1,8-Diazabicyclo[5.4.0]undec-7-en. Auch cycloaliphatische Polyamine können als Beschleuniger eingesetzt werden. Geeignet sind auch Beschleuniger auf Phosphatbasis wie Phosphine und/oder Phosphoniumverbindungen, wie beispielsweise Triphenylphosphin oder Tetraphenylphosphoniumtetraphenylborat.

Erfindungsgemäß kann es vorgesehen sein, dass auch ein an sich haftklebriger Polymerschaum mit einer aus Polyacrylat(en) bestehenden Polymerbasis ober- und/oder unterseitig mit einer Haftklebemasse beschichtet ist, wobei die Polymerbasis dieser Haftklebemasse bevorzugt ebenfalls aus Polyacrylaten besteht. Es können alternativ andere beziehungsweise anders vorbehandelte Klebeschichten, also beispielsweise Haftklebeschichten und/oder hitzeaktivierbare Schichten auf der Basis anderer Polymere als Poly(meth)acrylate zu der geschäumten Schicht kaschiert werden. Geeignete Basispolymere sind Naturkautschuke, Synthesekautschuke, Acrylatblockcopolymere, Vinylaromatenblockcopolymere, insbesondere Styrolblockcopolymere, EVA, Polyolefine, Polyurethane, Polyvinylether und Silikone. Bevorzugt enthalten diese Schichten keine nennenswerten Anteile an migrierfähigen Bestandteilen, die mit dem Material der geschäumten Schicht so gut verträglich sich, dass sie in signifikanter Menge in die geschäumte Schicht diffundieren und dort die Eigenschaften verändern.

Generell kann die Weichphase des erfindungsgemäßen Klebebandes mindestens ein klebrig machendes Harz enthalten. Als klebrig machende Harze sind insbesondere aliphatische, aromatische und/oder alkylaromatische Kohlenwasserstoffharze, Kohlenwasserstoffharze auf Basis reiner Monomere, hydrierte Kohlenwasserstoffharze, funktionelle Kohlenwasserstoffharze sowie Naturharze einsetzbar. Bevorzugt ist das klebrig machende Harz ausgewählt aus der Gruppe umfassend Pinen-, Inden- und Kolophoniumharze, deren disproportionierte, hydrierte, polymerisierte und/oder veresterte Derivate und Salze, Terpenharze und Terpenphenolharze sowie C5-, C9- und andere Kohlenwasserstoffharze. Auch Kombinationen dieser und weiterer Harze können vorteilhaft eingesetzt werden, um die Eigenschaften der resultierenden Klebmasse wunschgemäß einzustellen. Besonders bevorzugt ist das klebrig machende Harz ausgewählt aus der Gruppe umfassend Terpenphenolharze und Kolophoniumester.

Die Weichphase des erfindungsgemäßen Klebebandes kann einen oder mehrere Füllstoffe enthalten. Der oder die Füllstoff(e) kann/können in einer oder in mehreren Schichten der Weichphase vorliegen.

Bevorzugt umfasst die Weichphase einen Polymerschaum, und der Polymerschaum enthält teil- oder vollexpandierte Mikroballons, insbesondere, wenn die Polymerbasis des Polymerschaums ein oder mehrere Polyacrylat(e) umfasst und ganz besonders bevorzugt, wenn die Polymerbasis des Polymerschaums aus einem oder mehreren Polyacrylat(en) besteht. Bei Mikroballons handelt es sich um elastische Hohlkugeln, die eine thermoplastische Polymerhülle aufweisen; sie werden daher auch als expandierbare polymere Mikrosphären oder als Mikrohohlkugeln bezeichnet. Diese Kugeln sind mit niedrigsiedenden Flüssigkeiten oder verflüssigtem Gas gefüllt. Als Hüllenmaterial finden insbesondere Polyacrylnitril, Polyvinyldichlorid (PVDC), Polyvinylchlorid (PVC), Polyamide oder Polyacrylate Verwendung. Als niedrigsiedende Flüssigkeit sind insbesondere niedere Alkane, beispielsweise Isobutan oder Isopentan geeignet, die als verflüssigtes Gas unter Druck in der Polymerhülle eingeschlossen sind. Durch ein physikalisches Einwirken auf die Mikroballons, beispielsweise durch eine Wärmeeinwirkung - insbesondere durch Wärmezufuhr oder -erzeugung, hervorgerufen zum Beispiel durch Ultraschall oder Mikrowellenstrahlung - erweicht einerseits die äußere Polymerhülle, gleichzeitig geht das in der Hülle befindliche flüssige Treibgas in seinen gasförmigen Zustand über. Bei einer bestimmten Paarung von Druck und Temperatur - auch als kritische Paarung bezeichnet - dehnen sich die Mikroballons irreversibel aus und expandieren dreidimensional. Die Expansion ist beendet, wenn sich der Innen- und der Außendruck ausgleichen. Da die polymere Hülle erhalten bleibt, erzielt man so einen geschlossenzelligen Schaum.

Es ist eine Vielzahl an Mikroballontypen kommerziell erhältlich, wie zum Beispiel von der Firma Akzo Nobel die Expancel DU-Typen (dry unexpanded), welche sich im Wesentlichen über ihre Größe (6 bis 45 µm Durchmesser im unexpandierten Zustand) und ihre zur Expansion benötigte Starttemperatur (75°C bis 220°C) differenzieren.

Weiterhin sind unexpandierte Mikroballontypen auch als wässrige Dispersion mit einem Feststoff- beziehungsweise Mikroballonanteil von ca. 40 bis 45 Gew.-% erhältlich, darüber hinaus auch als polymergebundende Mikroballons (Masterbatche), zum Beispiel in Ethylvinylacetat mit einer Mikroballonkonzentration von ca. 65 Gew.-%. Ferner sind sogenannte Mikroballon-Slurry-Systeme erhältlich, bei denen die Mikroballons mit einem Feststoffanteil von 60 bis 80 Gew.-% als wässrige Dispersion vorliegen. Sowohl die Mikroballon-Dispersionen, die Mikroballon-Slurrys als auch die Masterbatche sind wie die DU-Typen zur Schäumung eines in der Weichphase des erfindungsgemäßen Klebebandes enthaltenen Polymerschaums geeignet.

Erfindungsgemäß besonders bevorzugt enthält der Polymerschaum Mikroballons, die im nicht expandierten Zustand bei 25 °C einen Durchmesser von 3 µm bis 40 µm, insbesondere von 5 µm bis 20 µm, und/oder nach Expansion einen Durchmesser von 10 µm bis 200 µm, insbesondere von 15 µm bis 90 µm, aufweisen.

Bevorzugt enthält der Polymerschaum bis zu 30 Gew.-% Mikroballons, insbesondere zwischen 0,5 Gew.-% und 10 Gew.-%, jeweils bezogen auf die Gesamtmasse des Polymerschaums.

Der Polymerschaum der Weichphase des erfindungsgemäßen Klebebandes - sofern diese einen Polymerschaum umfasst - ist bevorzugt gekennzeichnet durch die weitgehende Abwesenheit von offenzelligen Hohlräumen. Besonders bevorzugt weist der Polymerschaum einen Anteil von Hohlräumen ohne eigene Polymerhülle, also von offenzelligen Kavernen, von nicht mehr als 2 Vol-% auf, insbesondere von nicht mehr als 0,5 Vol.-%. Der Polymerschaum ist somit bevorzugt ein geschlossenzelliger Schaum.

Optional kann die Weichphase des erfindungsgemäßen Klebebandes auch pulver- und/oder granulatförmige Füllstoffe, Farbstoffe und Pigmente, insbesondere auch abrasive und verstärkende Füllstoffe wie zum Beispiel Kreiden (CaCO₃), Titandioxide, Zinkoxide und Ruße auch zu hohen Anteilen, das heißt von 0,1 bis 50 Gew.-%, bezogen auf die Gesamtmasse der Weichphase, enthalten.

Weiterhin können schwerentflammbare Füllstoffe wie beispielsweise Ammoniumpolyphosphat; elektrisch leitfähige Füllstoffe wie beispielsweise Leitruß, Kohlenstofffasern und/oder silberbeschichtete Kugeln; thermisch leitfähige Materialien wie beispielsweise Bornitrid, Aluminiumoxid, Siliciumcarbid; ferromagnetische Additive wie beispielsweise Eisen-(III)-oxide; weitere Additive zur Volumenerhöhung, wie beispielsweise Blähmittel, Glasvollkugeln, Glashohlkugeln, carbonisierte Mikrokugeln, phenolische Mikrohohlkugeln, Mikrokugeln aus anderen Materialien; Kieselsäure, Silicate, organisch nachwachsende Rohstoffe wie beispielsweise Holzmehl, organische und/oder anorganische Nanopartikel, Fasern; Alterungsschutzmittel, Lichtschutzmittel, Ozonschutzmittel und/oder Compoundierungsmittel in der Weichphase enthalten sein. Als Alterungsschutzmittel können bevorzugt sowohl primäre, z.B. 4-Methoxyphenol oder Irganox® 1076, als auch sekundäre Alterungsschutzmittel, z.B. Irgafos® TNPP oder Irgafos® 168 der Firma BASF, gegebenenfalls auch in Kombination miteinander, eingesetzt werden. Als weitere Alterungsschutzmittel können Phenothiazin (C-Radikalfänger) sowie Hydrochinonmethylether in Gegenwart von Sauerstoff sowie Sauerstoff selbst eingesetzt werden.

Die Dicke der Weichphase beträgt vorzugsweise 200 bis 1800 µm, besonders bevorzugt 300 bis 1500 µm, insbesondere 400 bis 1000 µm. Die Dicke der Weichphase wird erfindungsgemäß nach ISO 1923 bestimmt.

Die Verbindung von Hart- und Weichphase beziehungsweise auch von in der Hart- und/oder Weichphase vorgesehenen Schichten untereinander zum erfindungsgemäßen Klebeband kann beispielsweise durch Laminieren, Kaschieren oder Coextrusion erfolgen. Es ist möglich, dass Hart- und Weichphase direkt, das heißt unmittelbar, miteinander verbunden sind. Ebenso ist es möglich, dass zwischen Hart- und Weichphase eine oder mehrere haftvermittelnde Schicht(en) angeordnet ist/sind. Das erfindungsgemäße Klebeband kann darüber hinaus weitere Schichten enthalten.

Bevorzugt ist mindestens eine der miteinander zu verbindenden Schichten, stärker bevorzugt sind mehrere der miteinander zu verbindenden Schichten und ganz besonders bevorzugt sind alle der miteinander zu verbindenden Schichten mit Corona- (mit Luft oder Stickstoff), Plasma- (Luft, Stickstoff oder andere reaktive Gase beziehungsweise reaktive, als Aerosol einsetzbare Verbindungen) oder Flammenvorbehandlungsmethoden vorbehandelt.

Auf der Rückseite, das heißt auf der vom Substrat abgewandten Seite, der Hartphase ist bevorzugt eine Funktionsschicht aufgebracht, die beispielsweise Trenneigenschaften oder UV-stabilisierende Eigenschaften aufweist. Diese Funktionsschicht besteht bevorzugt aus einer Folie mit einer Dicke von ≤ 20 µm, besonders bevorzugt von ≤ 10 µm, insbesondere von ≤ 8 µm, beispielsweise von ≤ 5 µm oder einem Lack mit einer Dicke von ≤ 10 µm, besonders bevorzugt von ≤ 6 µm, insbesondere von ≤ 3 µm, beispielsweise von ≤ 1,5 µm. Sowohl die Folie als auch der Lack enthalten bevorzugt einen UV-Absorber, und/oder die Polymerbasis der Folie beziehungsweise des Lacks enthält UV-absorbierende und/oder UVabweisende Gruppen.

Folien können durch Laminieren, Kaschieren oder Coextrusion auf die Rückseite der Hartphase aufgebracht werden. Bei der Folie handelt es sich bevorzugt um eine metallisierte Folie. Die Polymerbasis der Folie ist bevorzugt ausgewählt aus der Gruppe bestehend aus Polyarylenen, Polyvinylchloriden (PVC), Polyethylenterephthalaten (PET), Polyurethanen, Polyolefinen, Polyutylenterephthalaten (PBT), Polycarbonaten, Polymethylmethacrylaten (PMMA), Polyvinylbutyralen (PVB), Ionomeren und Mischungen aus zwei oder mehreren der vorstehend aufgeführten Polymere. "Hauptbestandteil" bedeutet hier "Bestandteil mit dem größten Gewichtsanteil, bezogen auf das Gesamtgewicht der Folie". Mit Ausnahme der Polyarylene weisen alle aufgeführten Materialien der Folie bevorzugt einen hohen Gehalt an UV-Stabilisatoren auf.

In einer speziellen Ausführungsform besteht das erfindungsgemäße Klebeband in auf das Substrat gerichteter Reihenfolge aus einer Funktionsschicht (wie vorstehend beschrieben); einer Hartphase und einer Weichphase bestehend aus einer Haftklebeschicht, einem Polymerschaum, dessen Polymerbasis aus einem oder mehreren Polyolefinen besteht, und einer weiteren Haftklebeschicht. Die untere Haftklebeschicht kann mit einem Releaseliner abgedeckt sein, dieser wird jedoch nicht zum erfindungsgemäßen Klebeband gerechnet.

In einer weiteren speziellen Ausführungsform besteht das erfindungsgemäße Klebeband in auf das Substrat gerichteter Reihenfolge aus einer Funktionsschicht (wie vorstehend beschrieben); einer Hartphase und einer haftklebrigen Weichphase, deren Polymerbasis aus einem oder mehreren Polyacrylaten besteht. Auch bei dieser Ausführungsform kann die Unterseite, das heißt die dem Substrat zugewandte Seite, der Weichphase mit einem Releaseliner abgedeckt sein, dieser wird jedoch nicht zum erfindungsgemäßen Klebeband gerechnet.

Ein weiterer Gegenstand der Erfindung ist ein Solarmodul, das ein um zumindest einen Teil seiner Kanten geklebtes erfindungsgemäßes Klebeband umfasst.

Ein weiterer Gegenstand der Erfindung ist die Verwendung eines erfindungsgemäßen Klebebandes zum Schutz von Kanten eines Solarmoduls.

### Beispiele

### Methoden:

### A) Messung der Biegesteifigkeit

Die Biegesteifigkeit wurde mit einem Softometer KWS der Firma Wolf ermittelt. Dabei wird ein Probestreifen des zu untersuchenden Materials mit einer Größe von 15 mm x 75 mm auf dem Probentisch fixiert. Dieser ist um 30° schwenkbar, so dass ein zu untersuchendes Medium beim Schwenken einen Kraftsensor berührt. Die durch den Sensor ermittelte Kraft in mN stellt einen der Biegesteifigkeit vergleichbaren Wert dar.

### B) Dart-Drop-Test

Der Dart Drop Test wurde in Anlehnung an Kugelfallversuche (bspw. DIN 52306, 52338) und Steinschlagtests (vgl. DIN 20567-3) durchgeführt. Dieser Test sieht vor, dass ein durch Gravitation beschleunigtes Objekt auf ein Testsubstrat trifft und der dabei entstandene Schaden bewertet wird.

Eine punktgenaue Aufprallfläche wurde realisiert, indem das Projektil während des Falls in einem Rohr geführt wurde. Weiterhin besaß der Impaktor eine definierte Aufprallfläche und - form, um den Einfluss von punktuellen Belastungen gegenüber flächigen Belastungen untersuchen zu können. Als Einflussgröße des Projektils wurde die kinetische Energie beim Aufprall herangezogen, welche sowohl durch Masse als auch Fallhöhe variiert werden kann. Die Energie kann zum einen aus der Fallhöhe berechnet oder zum anderen über die Projektilgeschwindigkeit beim Aufprall bestimmt werden. Zur Ermittlung der Geschwindigkeit wurde eine Lichtschranke genutzt.

Als Impaktor wurde ein Edelstahlzylinder mit einer Aussparung verwendet. Der Impaktor hatte eine Aufprallfläche von 90 mm², die sich als Differenz aus der Fläche des dem Zylinder zugrunde liegenden Kreises und der Fläche der Aussparung ergab. Das Gewicht des Impaktors betrug 400 g.

Als Ergebnisgrößen wurden die Schädigung des Substrats und die Schädigung des Klebebandes herangezogen. Für die Untersuchungen wurde die Kante eines 6mm dicken Floatglases gewählt, auf die relevante Kantenschutzbänder aufgebracht wurden. Das Ausmaß der Schädigung von Kantenschutzband und Glas war die untersuchte Messgröße.

Zur Bewertung war pro Versuch ein Wert aus vier differenzierbaren Stufen zu wählen, welche eindeutig voneinander unterschieden werden konnten.

Dabei bedeuten:
Stufe 1: keine Schädigung bzw. nur minimale Deformation des Schutzbandes;
Stufe 2: deutliche Schäden am Kantenschutzband, Durchschlagen des Tapes;
Stufe 3: eindeutige Penetration des Tapes, jedoch ohne Schädigung der Glasoberfläche;
Stufe 4: Beschädigung des Floatglases.

Die Bewertung erfolgte anhand von Punkten, die für die einzelnen Kriterien zu vergeben waren. Dabei wurde zunächst das Auftreten von Schäden der Stufe 4 nach einem Ja/Nein-Schema bewertet. Wenn ein Schaden der Stufe 4 aufgetreten war, wurden in den Rubriken "Glasbruch" und "Schädigung" jeweils null Punkte vergeben.

War kein Schaden der Stufe 4 aufgetreten, wurden zunächst für das Kriterium "Glasbruch" 5 Basispunkte vergeben, die in Abhängigkeit von der Fallhöhe des Impaktors (1m, 1,5m und 2m) verdoppelt beziehungsweise verdreifacht wurden. Folglich wurden, sofern bei einer Fallhöhe von 2m kein Schaden der Stufe 4 feststellbar war, 15 Punkte für "Glasbruch" vergeben. Daneben wurde die Beschädigung des Klebebandes mit weiteren Punkten bewertet. Dabei wurden Schäden der Stufe 1 mit 5 Punkten bewertet, Schäden der Stufe 2 mit 3 Punkten und Schäden der Stufe 3 mit 1 Punkt, jeweils unter dem Kriterium "Schädigung".

Abschließend wurden noch Punkte für das sogenannte "Kantenabheben" vergeben, also für das Verbleiben des um die Kanten des Floatglases verklebten Klebebandes in der die Kanten umgebenden Position. Sofern dies vollumfänglich der Fall war, wurden 10 Punkte vergeben. Löste sich das Klebeband eindeutig vom Substrat, indem es sich aus der U-förmigen, die Kante umgebenden Lage durch Aufstellen der "Schenkel" des U löste, wurden null Punkte vergeben. Dazwischen waren entsprechende Abstufungen durch Vergabe von 2, 4, 6 oder 8 Punkten möglich (2 Punkte für starkes, aber nicht vollständiges Aufstellen/Ablösen, 8 Punkte für nur leichtes Ablösen).

Die erreichten Punkte wurden aufsummiert. Eine hohe Punktzahl entspricht einer Erfüllung der Anwendungskriterien, eine niedrigere Punktzahl signalisiert Mängel. Maximal waren entsprechend den vorstehenden Ausführungen 30 Punkte zu erreichen. Die Ergebnisse sind in Tabelle 1 zusammengefasst.

Hart- und Weichphasen:
Hartphase H1: PET-Folie der Dicke 12 µm
Hartphase H2: PET-Folie der Dicke 75 µm
Hartphase H3: PE-Folie der Dicke 135 µm
Hartphase H4: HDPE-Folie der Dicke 35 µm
Hartphase H5: PU-Folie der Dicke 300 µm

Weichphase W1: Schaum mit einer Dichte von 140 kg/m³ aus PE-EVA-Blend (70 Gew.-% PE, 30 Gew.-% EVA), Dicke 400 µm; ober- und unterseitig jeweils versehen mit einer harzmodifizierten Polyacrylat-Haftklebemasse der Dicke 50 µm

Weichphase W2: Schaum mit einer Dichte von 140 kg/m³ aus PE-EVA-Blend (70 Gew.-% PE, 30 Gew.-% EVA), Dicke 800 µm; ober- und unterseitig jeweils versehen mit einer harzmodifizierten Polyacrylat-Haftklebemasse der Dicke 50 µm

Weichphase W3: Selbstklebender Polyacrylat-Schaum der Dicke 800 µm

Weichphase W4: Polyacrylat-Schaum der Dicke 1000 µm, ober- und unterseitig jeweils versehen mit harzmodifizierter Poylacrylathaftklebemasse der Dicke 50 µm

Sofern in den Vergleichsversuchen keine (erfindungsgemäße) Weichphase verwendet wurde, wurden die Hartphasen mit einer harzmodifizierten Polyacrylat-Haftklebemasse der Dicke 50 µm auf dem Substrat verklebt.

**Tabelle 1: Ergebnisse Dart-Drop-Test**

| Nr. | Hartphase | Weichphase | Fallhöhe | Glasbruch | Schädigung | Kantenabheben | Σ |
|---|---|---|---|---|---|---|---|
| erfindungsgemäß | | | | | | | |
| 1 | H1 | W2 | 2m | 15 | 1 | 10 | 26 |
| 2 | H1 | W4 | 2m | 15 | 1 | 8 | 24 |
| 3 | H2 | W3 | 2m | 15 | 3 | 8 | 26 |
| 4 | H2 | W4 | 2m | 15 | 3 | 10 | 28 |
| 5 | H3 | W1 | 2m | 15 | 1 | 10 | 26 |
| 6 | H3 | W2 | 2m | 15 | 1 | 10 | 26 |
| 7 | H3 | W3 | 2m | 15 | 1 | 8 | 24 |
| 8 | H4 | W3 | 2m | 15 | 1 | 8 | 24 |
| 9 | H4 | W2 | 2m | 15 | 1 | 10 | 26 |
| | | | | | | | |

| Vergleich | | | | | | | |
|---|---|---|---|---|---|---|---|
| 10 | H5 | Keine | 2m | 0 | 0 | 10 | 10 |
| 11 | H2 | Keine | 2m | 0 | 0 | 8 | 8 |
| 12 | H4 | keine | 2m | 0 | 0 | 10 | 10 |
| 13 | Keine | W2 | 2m | 0 | 0 | 10 | 10 |

## Patentansprüche

1. Klebeband zum Schutz von Glaskanten, umfassend in auf das zu bedeckende Substrat gerichteter Reihenfolge eine Trägerschicht (Hartphase) und eine Weichphase umfassend einen Polymerschaum, eine viskoelastische Masse und/oder eine elastomere Masse, wobei die Dicke der Hartphase ≤ 150 µm beträgt, die Dicke der Weichphase ≥ 200 µm beträgt und das Verhältnis der Dicke der Weichphase zur Dicke der Hartphase ≥ 4 beträgt.

2. Klebeband gemäß Anspruch 1, **dadurch gekennzeichnet, dass** die Polymerbasis der Hartphase ausgewählt ist aus der Gruppe bestehend aus Polyvinylchloriden, Polyethylenterephthalaten, Polyurethanen, Polyolefinen, Polybutylenterephthalaten, Polycarbonaten, Polymethylmethacrylaten, Polyvinylbutyralen, Ionomeren und Mischungen aus zwei oder mehreren der vorstehend aufgeführten Polymere.

3. Klebeband gemäß mindestens einem der vorstehenden Ansprüche, **dadurch gekennzeichnet, dass** die Polymerbasis der Hartphase ausgewählt ist aus der Gruppe bestehend aus Polyvinylchloriden, Polyethylenterephthalaten, Polyurethanen, Polyolefinen und Mischungen aus zwei oder mehreren der vorstehend aufgeführten Polymere.

4. Klebeband gemäß mindestens einem der vorstehenden Ansprüche, **dadurch gekennzeichnet, dass** die Polymerbasis der Weichphase ausgewählt ist aus Polyolefinen, Polyacrylaten, Polyurethanen und Mischungen aus zwei oder mehreren der vorstehend aufgeführten Polymere.

5. Klebeband gemäß mindestens einem der vorstehenden Ansprüche, **dadurch gekennzeichnet, dass** die Polymerbasis der Weichphase ausgewählt ist aus Polyolefinen, Polyacrylaten und Mischungen aus zwei oder mehreren der vorstehend aufgeführten Polymere.

6. Klebeband gemäß mindestens einem der vorstehenden Ansprüche, **dadurch gekennzeichnet, dass** die Dicke der Weichphase bis zu 1800 µm beträgt.

7. Klebeband gemäß mindestens einem der vorstehenden Ansprüche, **dadurch gekennzeichnet, dass** die Hartphase eine Biegesteifigkeit von maximal 10 mN/mm aufweist.

8. Solarmodul, umfassend ein um zumindest einen Teil der Kanten des Solarmoduls geklebtes Klebeband gemäß mindestens einem der vorstehenden Ansprüche.

9. Verwendung eines Klebebandes gemäß mindestens einem der Ansprüche 1 bis 7 zum Schutz von Kanten eines Solarmoduls.
